Europäisches Patentamt

European Patent Office

Office européen des brevets

(11) Numéro de publication : **0 407 250 B1**

(12) **FASCICULE DE BREVET EUROPEEN**

(45) Date de publication du fascicule du brevet :
**19.05.93 Bulletin 93/20**

(51) Int. Cl.$^5$ : **H01L 31/0352, H01L 29/205**

(21) Numéro de dépôt : **90401714.2**

(22) Date de dépôt : **19.06.90**

(54) **Détecteur d'ondes électromagnétiques.**

(30) Priorité : **04.07.89 FR 8908961**

(43) Date de publication de la demande :
**09.01.91 Bulletin 91/02**

(45) Mention de la délivrance du brevet :
**19.05.93 Bulletin 93/20**

(84) Etats contractants désignés :
**DE FR GB**

(56) Documents cités :
**EP-A- 0 299 841**
**US-A- 4 671 830**
**APPLIED PHYSICS LETTERS, vol. 53, no. 20, 14 novembre 1988, pages 1961-1963, New York, US; S.R. KURTZ et al.: "High photoconductive gain in InAsSb strained-layer superlattice infrared detectors"**
**APPLIED PHYSICS LETTERS, vol. 50, no. 16, 20 avril 1987, pages 1092-1094, New York, US; B.F. LEVINE et al.: "New 10 mum infrared detector using intersubband absorption in resonant tunneling GaAlAs superlattices"**

(73) Titulaire : **THOMSON-CSF**
**51, Esplanade du Général de Gaulle**
**F-92800 Puteaux (FR)**

(72) Inventeur : **Delacourt, Dominique**
**THOMSON-CSF, SCPI, Cédex 67**
**F-92045 Paris la Défense (FR)**
Inventeur : **Papuchon, Michel**
**THOMSON-CSF, SCPI, Cédex 67**
**F-92045 Paris la Défense (FR)**
Inventeur : **Lehureau, Jean-Claude**
**THOMSON-CSF, SCPI, Cédex 67**
**F-92045 Paris la Défense (FR)**

(74) Mandataire : **Guérin, Michel et al**
**THOMSON-CSF, SCPI, B.P. 329, 50, rue Jean-Pierre Timbaud**
**F-92402 Courbevoie Cédex (FR)**

## Description

L'invention concerne un détecteur d'ondes électromagnétiques et plus précisément un détecteur d'ondes à semiconducteurs à puits quantiques.

A l'heure actuelle, plusieurs solutions peuvent être utilisées pour détecter une onde électromagnétique appartenant au domaine de l'infrarouge moyen, c'est-à-dire dont la longueur d'onde est située typiquement entre 2 et 20 µm. Parmi ces solutions, on peut citer l'utilisation de :
- a) matériaux semiconducteurs des groupes II-VI et IV-VI
- b) matériaux semiconducteurs du groupe IV dopés
- c) matériaux semiconducteurs III-V associés en structures à puits quantiques multiples.

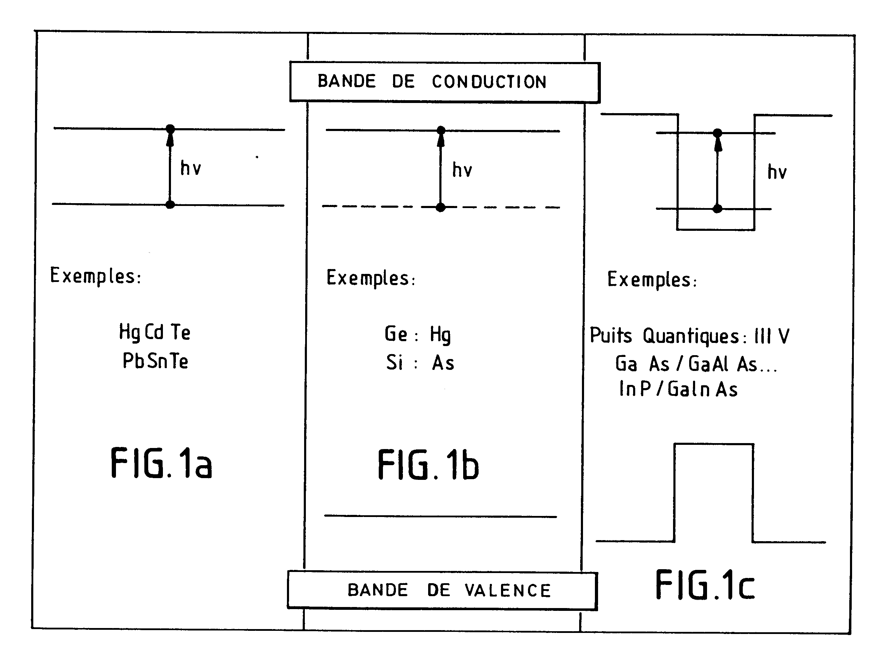

La première solution (a) consiste à mettre en oeuvre des matériaux semiconducteurs dont la largeur de bande interdite est plus faible que l'énergie photonique hν de l'onde à détecter qui permet donc de faire passer des électrons de la bande de valence à celle de conduction. Ces électrons sont ensuite collectés à l'aide d'un circuit extérieur et sont à l'origine d'un photocourant qui permet la détection (voir figure 1a). Parmi les matériaux dont la largeur de bande interdite est compatible avec ce type de fonctionnement dans l'infrarouge moyen, on peut citer les alliages II-VI du type HgCdTe et les alliages du groupe IV-VI du type PbSnTe.

La deuxième solution (b) prévoyant l'utilisation de semiconducteurs présentant une largeur de bande interdite plus grande que l'énergie photonique à détecter, est possible en ayant recours à un dopage des matériaux utilisés. Ce dopage permet de faire apparaître un niveau donneur d'électrons correspondant aux impuretés à l'origine du dopage. A partir de ce niveau énergétique, plus proche du bas de la bande de conduction que ne l'est le sommet de la bande de valence, vont pouvoir se produire des transitions électroniques vers la bande de conduction, rendant libres et détectables les électrons ayant subi ces transitions sous l'effet, en particulier, d'un champ électromagnétique infrarouge (voir figure 1b). A titre d'exemple, le dopage du silicium avec de l'arsenic (Si:As) ou du germanium avec du mercure (Ge:Hg), permet la détection dans un domaine spectral situé, en longueur d'onde, autour de 10 microns.

La troisième solution (c) est basée sur l'occurrence de transitions électroniques entre niveaux permis d'énergie ($e_1$ et $e_2$) au sein de la bande de conduction de structures quantiques semiconductrices. Comme cela est décrit dans les documents:
- High photo conductive gain in lateral InAsSb strained - layer superlattice infrared detectors" de S.R. KURTZ et al. publié dans Appl. Phys. Lett. 53 (20), 14 Novembre 1988, pages 1961-1963

- demande de brevet européen EP-A-299841

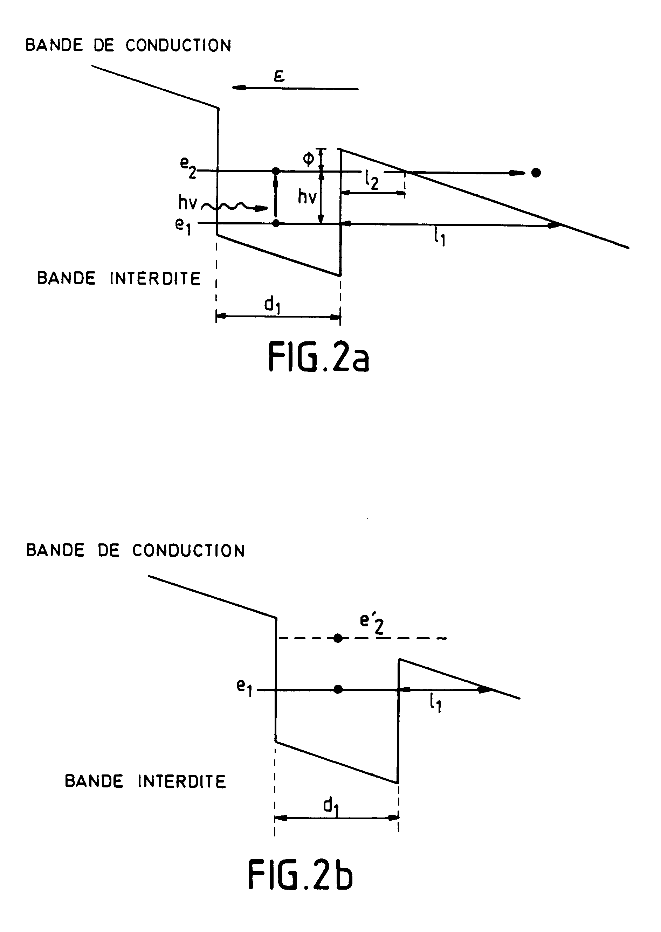

La figure 1c donne un exemple de ce type de transition dans un puits présentant deux niveaux discrets d'énergie permise pour les électrons. L'application d'un champ électrique à ce type de configuration permet, comme l'indiquent les figures 2a et 2b, d'extraire du puits de manière préférentielle, les électrons situés sur le niveau quantique excité (e2 sur figure 2a et e'2 sur la figure 2b). Ainsi, la collection dans le circuit électrique extérieur de ces électrons provenant du deuxième niveau quantique sur lequel ils ont été portés par un éclairement infrarouge (hν), permet la détection de cet éclairement. La solution objet de l'invention concerne ce troisième type (c) de détecteurs infrarouges.

Le type de détecteur auquel s'applique l'invention, est donc basé sur l'occurrence, sous l'effet d'un éclairement infrarouge, de transitions électroniques au sein de la bande de conduction de puits quantiques semiconducteurs. La principe de fonctionnement de ces détecteurs est donc d'utiliser ces transitions pour placer les électrons initialement situés sur le niveau fondamental du puits, à un niveau énergétique leur permettant de sortir facilement du puits sous l'effet d'un champ électrique appliqué. Jusqu'à présent deux configurations correspondant aux solutions des figures 2a et 2b précédentes ont été proposées pour rendre possible ce type de fonctionnement. La solution de la figure 2a consiste à utiliser un puits quantique présentant deux niveaux $e_1$ et $e_2$ d'énergie permise pour les électrons dans la bande de conduction. Sous l'effet d'un éclairement représenté par son énergie photonique hν sur la figure 2a, des transitions électroniques peuvent se produire du niveau $e_1$ vers le niveau $e_2$. L'application d'un champ électrique E à la structure permet ensuite de faire franchir aux électrons situés sur le niveau $e_2$, la barrière de potentiel φ afin de les extraire du puits. Les électrons participent alors à un photocourant qui permet la détection de l'éclairement.

Des dispositions de ce type ont été décrites dans les articles suivants :
- New 10 µm infrared detector using intersubband absorption in resonant tunneling GaA1As superlattices", B. F. Levine, K.K. Choi, C.G. Bethea, J. Walker and R.J. Malik, Appl. Phys. Lett. 50 (16), 20 April 1987, p. 1092
- "Multiple quantum well 10 µm GaAs/Al$_{(x)}$ Ga$_{(1-x)}$ As infrared detector with improved responsivity", K.K. Choi B.F. Levine, C.G. Bethea, J. Walker and R.J. Malik Appl. Phys. Lett. 50 (25), 22 june 1987, p. 1814.
- "Quantum well avalanche multiplication initiated by 10 µm intersubband absorption and photoexcited tunneling", B. F. Levine, K.K. Choi, C. G. Bethea, J. Walker and R. J. Malik, Appl. Phys. Lett. 51 (12), 21 September 1987, p. 934.

La configuration de la figure 2b est basée sur l'emploi d'un puits ne présentant qu'un seul niveau lié e1, séparé du haut de la barrière formant le puits par une énergie voisine de l'énergie photonique hν de l'onde électromagnétique à détecter (voir figure 2b). Les transitions se produisent entre ce niveau et un niveau virtuel situé dans le continuum.

Des dispositifs de ce type ont été décrits dans les articles suivants :
- "GaAs/AlGaAs quantum-well long-wavelength infrared (LWIR) detector with a detectivity comparable to HgCdTe", B.F. Levine, C. G. Bethea, G. Hasnain, J. Walker, R. J. Malik, Electron. Letters, Vol 24, N° 12, 9/6/88, p. 747
- High detectivity D∗=1.0 x 10$^{10}$ cm $\sqrt{Hz}$/W GaAs/AlGaAs multiquantum well 8. 3 µm infrared detector", B. F. Levine, C.G. Bethea, G. Hasnain, J. Walker and R. J. Malik, Appl. Phys. Lett. 53(4), 25 July 1988, p. 296.

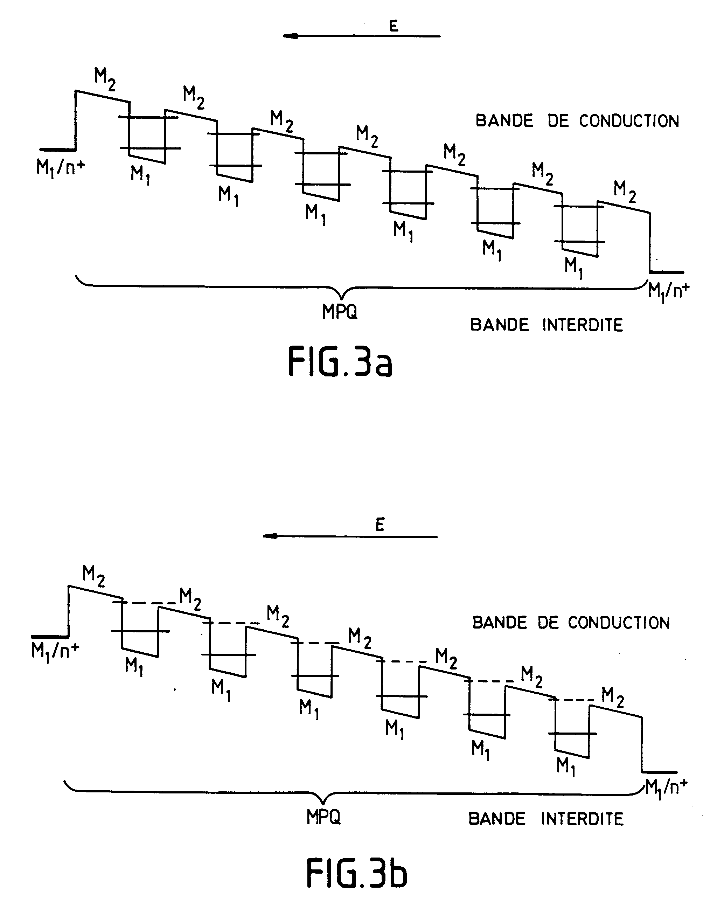

Pour obtenir une absorption importante de l'éclairement à détecter on utilise un grand nombre de puits au sein des détecteurs basés sur ce principe quantique, et ce, quelle que soit la solution choisie figure 2a ou figure 2b. Ainsi la bande de conduction de ces détecteurs à multi-puits quantiques (MPQ) peut être symbolisée par les figures 3a et 3b. Ces figures 3a et 3b correspondant respectivement aux deux types de transitions qui viennent être évoqués en relation avec les figures 2a et 2b. Ce type de structure est basé sur l'empilement périodique de couches d'un premier matériau $M_1$ et d'un deuxième matériau $M_2$. Les largeurs de bandes interdites des deux matériaux sont différentes afin d'obtenir des puits de potentiel pour les électrons dans la bande de conduction. Les couches de contact situées de part et d'autres de la région périodique désignée par MPQ, peuvent par exemple être constituées de couches de matériau $M_1$ fortement dopées n et notées $M_1$/n+. Pour augmenter le nombre de transitions possibles, on a recours généralement au dopage de type n de la zone MPQ.

Parmi les caractéristiques présentées par les deux solutions, on peut noter, en se reportant à nouveau aux figures n° 2a et 2b, les éléments suivants :
- dans le cas de la solution de la figure 2a, les transitions se produisent entre deux niveaux situés au dessous de la barrière de potentiel séparant les puits. Par conséquent les électrons situés sur les deux niveaux présentent un confinement important dans la largeur $d_1$ des puits, d'où une efficacité de transition importante entre les deux niveaux. Le fonctionnement de ce type de détecteur tire parti de la différence de mobilité dans la direction perpendiculaire au plan des couches constituant les puits, entre les électrons situés sur le niveau $e_1$ et ceux situés sur le niveau $e_2$. En effet pour être extraits du puits, les électrons situés sur le niveau $e_2$ ont une barrière de potentiel φ à franchir plus faible que les électrons situés sur le niveau $e_1$ retenus sous champ dans le puits par une barrière φ + hν). De plus, la largeur de cette barrière est plus fine ($1_2$) pour le niveau $e_2$ que pour le niveau $e_1$ ($1_1$) et ce à cause du profil de potentiel imprimé à la structure par le champ électrique utilisé pour la collection des photoélectrons. Néanmoins, cette barrière de potentiel à franchir limite les performanures du détecteur car elle limite la différence de mobilité dans le transport perpendiculaire aux couches semiconductrices entre les électrons situés sur le niveau $e_1$ et ceux situés sur le niveau $e_2$, les deux niveaux étant séparés par l'énergie hν donnée par la longueur d'onde centrale de la courbe de réponse de détecteur.

Si l'on observe cette fois la figure 2b, on constate dans cette hypothèse, que les électrons excités par le champ électromagnétique à détecter n'ont plus de barrière à franchir pour être extraits du puits, ce qui favorise leur participation au photo-courant. Par contre, le niveau e'2 auquel sont portés les électrons photo-excités à partir du niveau $e_1$, est virtuel et la probabilité de transition beaucoup plus petite que le cas de la figure 2a, compte-tenu de la très faible localisation dans la zone du puits, des électrons situés sur ce niveau virtuel e'2. En d'autres termes, la fonction d'onde associée à ce niveau n'est pas confinée dans la zone du puits.

Toujours à titre de comparaison entre les deux configurations connues (figures 2a et 2b), signalons également que dans le premier cas (figure 2a), la distance $1_2$, dépend directement du champ appliqué à la structure. Plus on cherche à diminuer $1_2$, plus on doit appliquer un champ important et plus on diminue $1_1$, ce qui a pour conséquence d'augmenter le courant d'obscurité de la structure. Ce problème est différent dans le cas de la figure 2b où des champs plus faibles peuvent être suffisants pour collecter efficacement les porteurs photo-excités, mais où se pose, nous l'avons vu, le problème de la faible probabilité de transition entre le niveau fondamental du puits et le niveau virtuel excité. Les solutions connues ne permettent donc pas d'associer d'une part une réponse importante due à une forte probabilité de transition entre niveau fondamental et niveau excité e'2, et d'autre un très faible courant d'obscurité. Ceci devient possible grâce à l'invention proposée ici, comme le montre le paragraphe suivant.

Pour répondre au problème posé qui consiste à obtenir sur un même détecteur basé sur l'occurrence de transitions intrabandes au sein de la bande de conduction de structures à puits quantiques multiples, une réponse élevée et un faible courant d'obscurité, il est nécessaire que la barrière à franchir soit très différente pour les électrons situés sur le niveau excité et pour ceux situés sur le niveau fondamental. La solution proposée consiste à donner au puits un profil de potentiel particulier.

C'est pourquoi l'invention concerne un détecteur d'onde électromagnétique pour la détection d'onde (hν) à détecter comprenant :

- une structure semiconductrice possédant au moins une première couche (1) d'un premier matériau encadrée entre une deuxième et une troisième couches (2, 3) d'un deuxième matériau, l'ensemble étant encadré par une quatrième et une cinquième couches (4, 5) d'un troisième matériau, cette structure permettant d'obtenir le profil suivant d'énergie potentielle correspondant au bas de la bande de conduction pour les électrons ;
- énergie relativement faible pour la première couche fournissant une référence (0) des énergies ;
- énergie intermédiaire pour les deuxième et troisième couche ;
- énergie de valeur supérieure pour les quatrième et cinquième couche ;

caractérisé en ce que
l'énergie totale permise correspondant à un premier niveau fondamental (e1 ) étant inférieure à l'énergie potentielle (V1) du bas de la bande de conduction de l'un et l'autre des matériaux utilisés pour fabriquer les deuxième et troisième couches, l'énergie totale permise correspondant à un deuxième niveau (e2) étant comprise entre l'énergie potentielle (V1) du bas de la bande de conduction de l'un et l'autre des matériaux des deuxième et troisième couches et l'énergie potentielle (V1 + V2) du bas de la bande de conduction de l'un et l'autre des matériaux des quatrième et cinquième couche ;

- des moyens de peuplement d'électrons du premier niveau d'énergie discret (e1) du puits quantique ;
- des moyens d'application d'un champ électrique perpendiculairement au plan de la structure.

L'invention concerne également un détecteur d'onde électromagnétique pour la détection d'onde (hν) à détecter comprenant :

- une structure semiconductrice possédant au moins une première couche (1) d'un premier matériau encadrée entre une deuxième et une troisième couches (2, 3) d'un deuxième matériau, l'ensemble étant encadré par une quatrième et une cinquième couches (4, 5) d'un troisième matériau, cette structure permettant d'obtenir le profil suivant d'énergie potentielle correspondant au sommet de la bande de valence pour les trous :
- énergie relativement faible pour la première couche fournissant une référence des énergies ;
- énergie intermédiaire pour les deuxième et troisième couches ;
- énergie de valeur supérieure pour les quatrième et cinquième couches,
  l'énergie totale permise correspondant à un premier niveau fondamental (e1) étant inférieure à l'énergie potentielle (V1) du sommet de la bande de valence de l'un et l'autre les matériaux utilisés pour fabriquer les deuxième et troisième couches, l'énergie totale permise correspondant à un deuxième niveau (e2) étant comprise entre l'énergie potentielle (V1) du sommet de la bande de valence de l'un et l'autre des matériaux des deuxième et troisième couches et l'énergie potentielle (V1 + V2) du sommet de la bande de valence de l'un et l'autre des matériaux des quatrième et cinquième couches (4, 5),

- des moyens de peuplement en trous du premier niveau permis d'énergie du puits quantique.

Les différents objets et caractéristiques de l'invention apparaîtront plus clairement dans la description qui va suivre faite à titre d'exemple en se reportant aux figures annexées qui représentent :

- les figures 1a à 3b, des diagrammes de niveaux d'énergie d'exemples de détecteurs connus dans la technique et décrits précédemment ;
- la figure 4a, un diagramme des niveaux d'énergie d'un exemple de réalisation d'un détecteur conforme à l'invention ;
- la figure 4b, un exemple de dispositif à semiconducteurs présentant un diagramme de bande de conduction tel que celui représenté en figure 4a ;
- les figures 5 et 6, des diagrammes de bandes de conduction du dispositif de la figure 4b soumis à des champs électriques ;
- les figures 7 et 8, des diagrammes de bandes de conduction de dispositifs du type de celui de la figure 4b possédant plusieurs niveaux d'énergie ;
- la figure 9, un autre exemple de réalisation de la structure de l'invention ;
- la figure 10, le diagramme de bande de conduction d'une variante de réalisation selon l'invention.

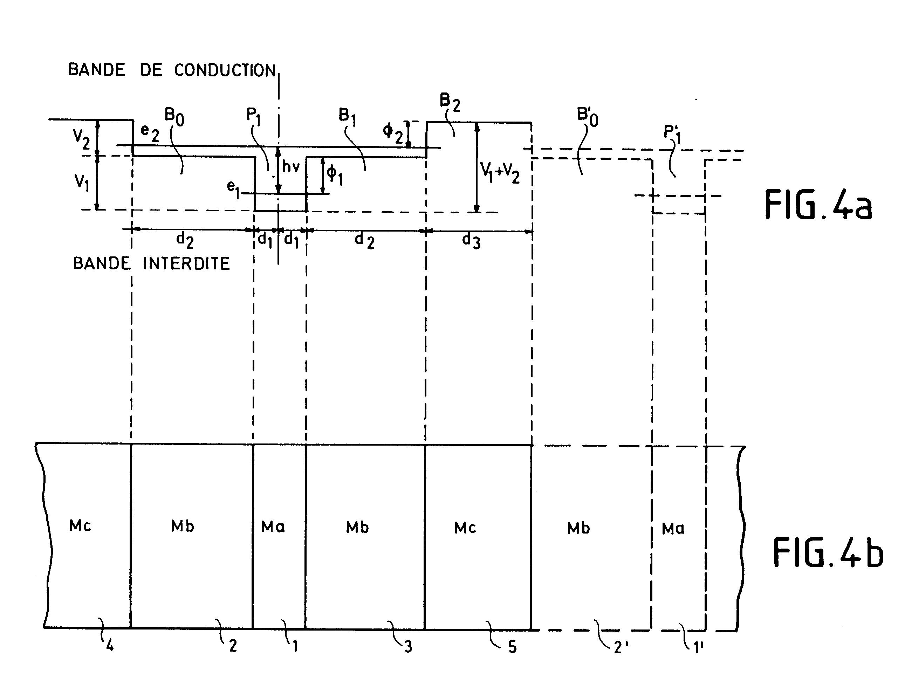

L'invention est un détecteur infrarouge basé sur l'occurrence de transitions électroniques entre deux niveaux quantiques $e_1$ et $e_2$ permis pour les électrons au sein du puits de potentiel dont le profil est représenté sur la figure 4a.

Un tel profil de la bande de conduction est obtenu à l'aide d'une structure représentée en figure 4b comprenant une couche 1 d'un premier matériau Ma encadrée entre deux couches 2 et 3 d'un deuxième matériau Mb l'ensemble étant lui-même encadré par deux couches 4 et 5 d'un troisième matériau Mc.

La couche 1 a une largeur de bande interdite inférieure à celle des couches 2 et 3 et la largeur de bande interdite des couches 2 et 3 est elle-même inférieure à celle des couches 4 et 5.

Les couches 1 à 5 constituent donc un puits quantique tel que représenté en figure 4a constituant des barrières intermédiaires ou des barrières échelonnées (B1, B2).

Plusieurs ensembles de couches 1 à 5 ainsi décrites peuvent être accolés et l'association de plusieurs puits de ce type pour cumuler l'effet recherché sur chacun de ces puits, conduit à une forme de bande de conduction, c'est-à-dire un profil d'énergie potentielle, également représenté sur la figure 4 où sont indiqués les paramètres importants de la structure. L'écart énergétique entre les niveaux d'énergie $e_1$ et $e_2$ dépend principalement des paramètres $d_1$, $d_2$, $V_1$, $V_2$.

Cet écart entre les niveaux $e_1$ et $e_2$ peut être également modifié par la largeur $d_3$ de la barrière la plus haute dans le cas où celle-ci est assez fine pour autoriser le couplage entre les niveaux $e_2$ de deux puits consécutifs. Pour la conception des structures, les valeurs de ces différents paramètres devront donc être déterminées pour que le dispositif présente effectivement une absorption et une détectivité importantes pour l'énergie photonique $h\nu$ désirée.

L'invention repose également sur le fait que le niveau $e_1$ se situe à une énergie potentielle inférieure à $V_1$ et que le niveau $e_2$ se situe lui à une énergie potentielle comprise entre $V_1$ et $V_1 + V_2$. En pratique on cherchera à obtenir une valeur importante pour $\phi_1$ afin de limiter le courant d'obscurité. A noter encore que la réalisation de cette structure nécessite au moins trois matériaux $M_a$, $M_b$, $M_c$ de largeur de bande interdite différente.

Sur la figure 4, on voit donc que deux puits consécutifs sont séparés par deux des barrières de niveaux différents. Nous avons donc des barrières échelonnées.

Cependant, des détecteurs à barrières échelonnées faisant appel à un plus grande nombre de matériaux sont également envisagés dans le cadre de l'invention. Un plus grand nombre de matériaux peut en effet permettre d'augmenter le nombre d'échelons par barrière ou de rendre les puits dissymétriques les dotant de barrières différentes à droite et à gauche.

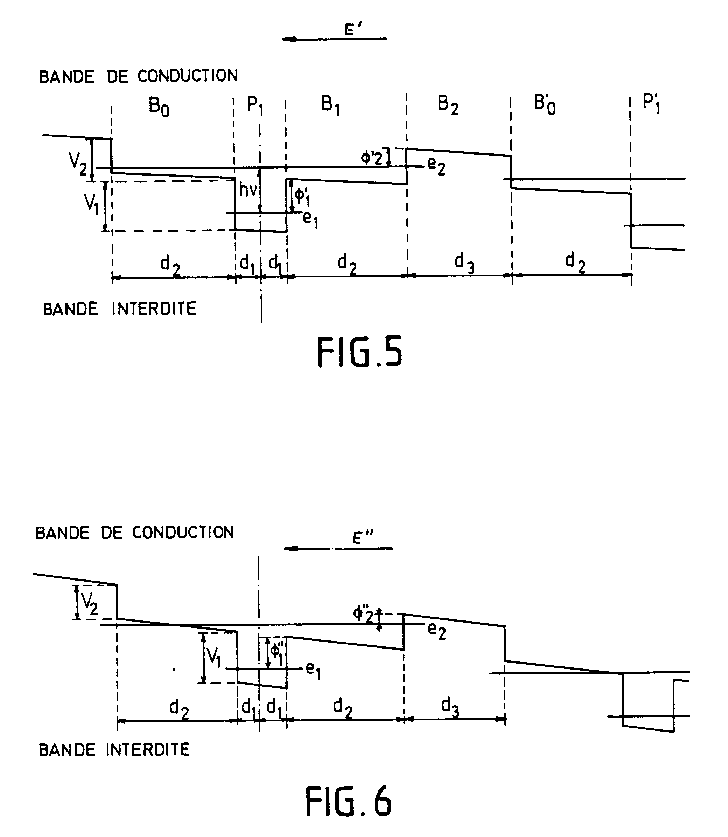

Sous un faible champ E', le diagramme de la bande de conduction devient celui de la figure 5. L'effet tunnel entre les niveaux $e_1$ de deux puits consécutifs est très fortement limité à cause de la barrière $B_1 + B_2 + B'0$, c'est-à-dire $d_2 + d_3 + d_2$ à franchir. A noter également que la hauteur de barrière $V_1 + V_2$, plus grande dans la zone centrale de largeur $d_3$ que dans les deux zones contigües de largeur $d_2$, accentue cette limitation. Par contre, pour ce qui concerne les électrons situés sur le niveau $e_2$, leur transport perpendiculaire est facilité par la faible hauteur de barrière $\phi_2$ et la faible épaisseur $d_3$ de la barrière $B_2$ ($d_3 < d_3 + 2d_2$).

Lorsque le champ appliqué augmente jusqu'à une valeur E" pour donner à la structure de bande la forme indiquée sur la figure 6 et peut atteindre les conditions de fonctionnement de ce type de détecteur, la barrière $\phi"_2$ diminue plus rapidement que la barrière $\phi'_1$. En effet, pour un champ donné, la variation de potentiel par rapport au centre d'un puits est plus grande à la distance $d_1 + d_2$ de ce centre qu'à la distance $d_1$, ce qui peut s'écrire : $E"(d_1 + d_2) > E'd_1$. Par conséquent, cette configuration originale permet de favoriser le passage dans le continuum, sous l'effet d'un champ électrique, des électrons situés sur le niveau $e_2$, tout en maintenant une barrière importante pour les électrons situés sur le niveau $e_1$ qui n'ont pas été excités par l'onde à détecter et dont le transport perpendiculaire aux couches quantiques correspond à un courant d'obscurité. Néanmoins le niveau $e_2$ reste confiné puisque son niveau énergétique se situe au dessus de $V_2$. Par conséquent, puisque les électrons situés sur les niveaux $e_1$ et $e_2$ sont confinés dans la région du puits, la probabilité de transition reste importante contrairement à ce qu'il advient si on utilise la solution connue de la figure 2b décrite précédemment. Cette configuration originale permet donc de limiter le courant d'obscurité tout en augmentant la réponse des détecteurs du type MPQ (Multi-Puits Quantiques). Il est à noter que la largeur $d_3$ de la barrière peut jouer également un rôle important clans ce type de dispositif. En effet, si $d_3$ est suffisamment grand, compte-tenu de la hauteur de $\phi_{2'}$, les puits pourront être considérés comme découplés puisque les extensions des fonctions d'onde ne permettront pas ce couplage entre niveaux $e_2$ consécutifs et encore moins entre niveaux $e_1$. Si la dimension $d_3$ est assez petite pour permettre le couplage entre niveaux $e_2$ consécutifs, un effet tunnel entre ces niveaux le long de la structure pourrait avoir lieu sous faible champ appliqué, ce qui pourrait favoriser la réponse du détecteur dans ces conditions de faible champ, donc de faible courant d'obscurité.

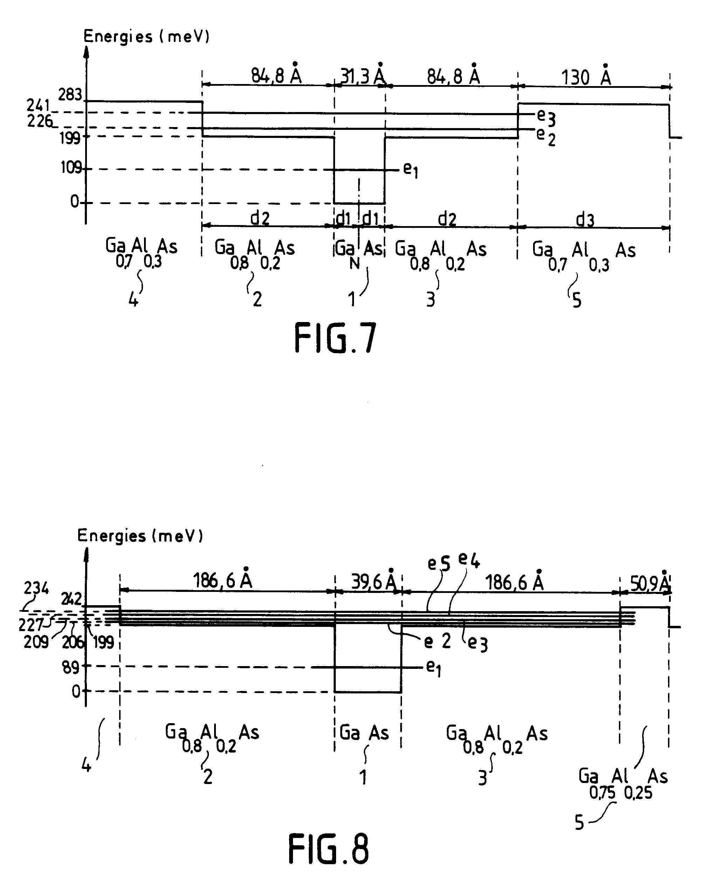

La figure 7 représente la bande de conduction d'un exemple de réalisation d'une structure selon l'invention. Cette structure qui est un exemple de réalisation détaillé de la structure de la figure 4b comporte :

- une couche 1 en arséniure de gallium ;
- des couches 2 et 3 en arséniure de gallium et d'aluminium de formule générale $Ga_{1-x}Al_xAs$ ; à titre d'exemple sur la figure 7, x vaut 0,2 et la formule est $Ga_{0,8}Al_{0,2}As$ ;
- des couches 4 et 5 en arséniure de gallium et d'aluminium de formule générale $Ga_{1-y}Al_yAs$ ; à titre d'exemple sur la figure 7, y vaut 0,3 et la formule est $Ga_{0,7}Al_{0,3}As$.

Cette structure constitue un puits quantique présentant un premier niveau lié e1 inférieur à l'énergie potentielle (V1) du bas de la bande de conduction des matériaux des couches 2 et 3, ainsi que deux niveaux d'énergie e2 et e3 tels que le niveau e2 est compris entre le bas de la bande de conduction des matériaux des couches 2 et 3 et le bas de la bande de conduction des matériaux des couches 4 et 5. Pour cet exemple les transitions utiles à la détection doivent se produire entre les niveaux $e_1$ et $e_2$.

Selon un deuxième exemple de réalisation de l'invention, la structure peut être telle que l'on ait une bande de conduction telle représentée en figure 8 :

- la couche 1 est en GaAs et a pour épaisseur 3,96 nm (39,6 Angstroems) ;
- les couches 2 et 3 sont en $Ga_{0,8} Al_{0,2}$ As et ont pour épaisseurs 18,66 nm (186,6 Angstroems) ;
- les couches 4 et 5 sont en $Ga_{0,75} Al_{0,25}$ As et ont pour épaisseurs 5,09 nm (50,9 Angstroems).

Cette structure présente un certain nombre de niveaux d'énergie 5 par exemple, c'est-à-dire le premier niveau e1 et le deuxième niveau $e_2$ situés comme décrit précédemment (à 89 meV et 206 meV) plus trois niveaux e3, e4, e5. Pour cet exemples les transitions utiles à la détection doivent se produire entre les niveaux $e_1$ et $e_2$.

Pour la détermination des niveaux, autres que le niveau fondamental $e_1$, on n'a pas tenu compte de leur couplage possible entre puits, ce couplage se traduisant par un élargissement de ces niveaux pouvant aller jusqu'à la création de mini bandes.

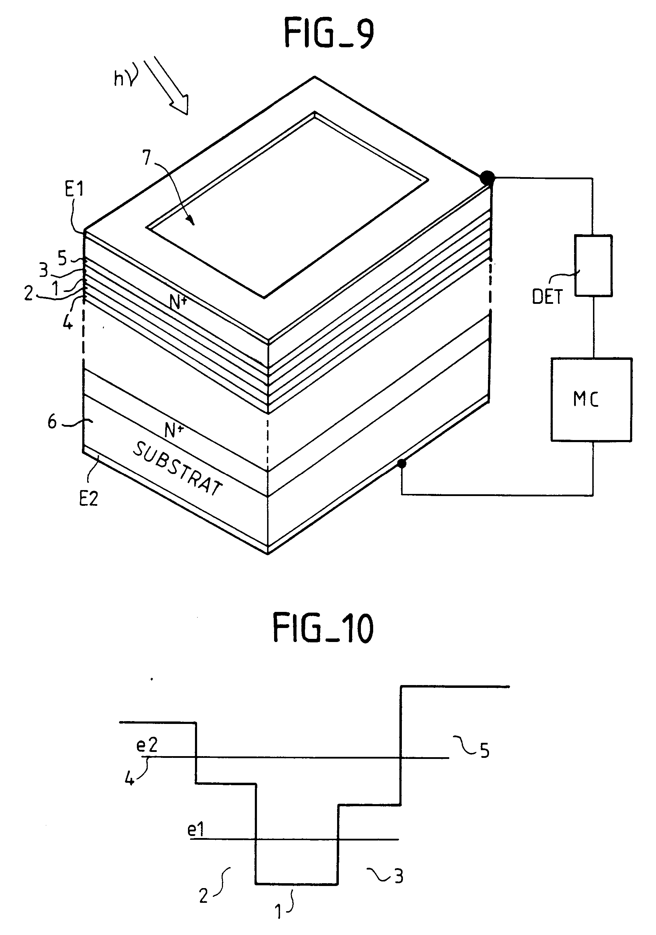

La figure 9 représente une structure de détecteur de l'invention. On retrouve les couches 1 à 5 décrites précédemment, reproduites plusieurs fois comme cela est indiqué par les pointillés pour former un multi-puits quantique.

L'ensemble est supporté par un substrat 6 qui peut être en matériau semi-isolant.

Deux électrodes E1 et E2 permettent d'appliquer un champ électrique à la structure sous la commande d'un générateur de commande MC. L'électrode E1 possède une fenêtre 7 permettant de transmettre un flux lumineux h à détecter à la structure.

Les niveaux d'énergie $e_1$ des puits quantiques peuvent être peuplés en électrons par dopage comme cela est indiqué précédemment, par exemple par dopage de type N de l'une quelconque au moins des couches 1 à 5, ou peuvent être peuplés en trous par dopage de type P de l'une quelconque au moins des couches 1 à 5.

Ces niveaux d'énergie $e_1$ peuvent aussi être peuplés en électrons par éclairement par une onde lumineuse de pompage dans le proche infra-rouge fournie par des moyens non représentés.

Dans les deux cas le détecteur fonctionne et détecte le rayonnement hν lorsqu'un champ électrique est appliqué par le générateur MC.

Cette détection se fait à l'aide d'un détecteur de courant DET connecté en série dans le circuit d'application du champ électrique.

L'invention concerne donc le domaine de la détection d'une onde électromagnétique grâce à l'utilisation de transitions électroniques entre niveaux discrets d'énergie au sein de la bande de conduction de puits quantiques qui peuvent être associés en nombre important pour augmenter la réponse de ce type de détecteurs. A l'heure actuelle, les solutions existantes dans ce domaine particulier, ne permettent pas de manière satisfaisante de limiter le courant d'obscurité tout en conservant une réponse suffisante.

L'invention concerne une structure utilisant pour les deux barrières qui constituent le puits, une forme à échelon qui permet de faire fonctionner le détecteur entre deux niveaux discrets $e_1$ et $e_2$ tout en favorisant l'extraction du puits, des électrons situés sur le niveau $e_2$. Cette forme de barrière revient à donner au puits une plus petite dimension pour les électrons situés sur le niveau $e_1$ que pour ceux situés sur le niveau $e_2$ qui restent néanmoins confinés dans la zone du puits, ce qui permet de maintenir une probabilité de transition $e_1$ vers $e_2$ importante. De plus cette configuration originale permet, lorsque plusieurs de ces puits sont associés pour augmenter la réponse du dispositif, de limiter le courant d'obscurité dû en particulier au transport, le puits en puits, d'électrons situés sur le niveau $e_1$. Par contre, la barrière de potentiel "vue" par les électrons situés sur le niveau $e_2$ est beaucoup plus faible et facilite le transport le long de la structure de ces électrons photo-excités. Ainsi, l'utilisation de puits à barrières échelonnées permet d'optimiser le rapport réponse/courant d'obscurité.

Dans ce qui précède on a considéré que les matériaux des couches 2 et 3, d'une part, étaient les mêmes et les matériaux des couches 4 et 5 d'autre part étaient les mêmes. Cependant cela peut n'être pas le cas comme cela est représenté en figure 10. Pour que le dispositif fonctionne code décrit précédemment, il faut que les niveaux e1 et e2 soient situés :

- pour e1 à un niveau inférieur à l'énergie potentielle du bas de la bande de conduction des matériaux des deux couches 2 et 3 ;
- pour e2 à un niveau compris entre les énergies potentielles du bas de bandes conduction des matériaux des couches 2 et 3 d'autre part, et des couches 4 et 5 d'autre part.

Par ailleurs, les exemples de réalisation ont été décrits précédemment en se référant aux bandes de conduction. Cependant, la description de l'invention serait la même en se référant aux bandes de valence des matériaux.

## Revendications

1. Détecteur d'onde électromagnétique pour la détection d'onde (hν) à détecter comprenant :
   - une structure semiconductrice possédant au moins une première couche (1) d'un premier matériau encadrée entre une deuxième et une troisième couches (2, 3) d'un deuxième matériau, l'ensemble étant encadré par une quatrième et une cinquième couches (4, 5) d'un troisième matériau, cette structure permettant d'obtenir le profil suivant d'énergie potentielle correspondant au bas de la bande de conduction pour les électrons:

- énergie relativement faible pour la première couche (1) fournissant une référence (0) des énergies ;
- énergie intermédiaire pour les deuxième et troisième couches (2, 3) ;
- énergie de valeur supérieure pour les quatrième et cinquième couches (4, 5),
caractérisé en ce que :
l'énergie correspondant à un premier niveau permis (e1) étant inférieure à l'énergie potentielle (V1) du bas de la bande de conduction de l'un et l'autre des matériaux utilisés pour fabriquer les deuxième et troisième couches (2, 3), l'énergie correspondant à un deuxième niveau (e2), étant comprise entre l'énergie potentielle (V1) du bas de la bande de conduction de l'un et l'autre des matériaux des deuxième et troisième couches (2, 3) et l'énergie potentielle (V1 + V2) lu bas de la bande de conduction de l'un et l'autre des matériaux des quatrième et cinquième couches (4,5) ;
- des moyens de peuplement d'électrons du premier niveau permis (e1) d'énergie du puits quantique ;
- des moyens d'application d'un champ électrique perpendiculairement au plan de la structure.

2. Détecteur d'onde électromagnétique pour la détection d'onde (hν) à détecter comprenant :
- une structure semiconductrice possédant au moins une première couche (1) d'un premier matériau encadrée entre une deuxième et une troisième couches (2, 3) d'un deuxième matériau, l'ensemble étant encadré par une quatrième et une cinquième couches (4, 5) d'un troisième matériau, cette structure permettant d'obtenir le profil suivant d'énergie potentielle correspondant au sommet de la bande de valence pour les trous :
- énergie relativement faible pour la première couche (1) fournissant une référence (0) des énergies ;
- énergie intermédiaire pour les deuxième et troisième couches (2, 3) ;
- énergie de valeur supérieure pour les quatrième et cinquième couches (4, 5),
caractérisé en ce que :
l'énergie correspondant à un premier niveau permis étant inférieure à l'énergie potentielle (V1) du sommet de la bande de valence de l'un et l'autre des matériaux utilisés pour fabriquer les deuxième et troisième couches (2, 3), l'énergie correspondant à un deuxième niveau (e2) étant comprise entre l'énergie potentielle (V1) du sommet de la bande de valence de l'un et l'autre des matériaux des deuxième et troisième couches (2, 3) et l'énergie potentielle (V1 + V2) du sommet de la bande de valence de l'un et l'autre des matériaux des quatrième et cinquième couches (4, 5),
- des moyens de peuplement en trous lui premier niveau permis d'énergie du puits quantique.

3. Détecteur selon la revendication 1, caractérisé en ce que la structure semiconductrice possède plusieurs niveaux (e2 à e5) compris entre l'énergie potentielle (V1) du bas de la bande de conduction des matériaux les deuxième et troisième couches (2, 3) et l'énergie potentielle (V1 + V2) du bas de la bande de conduction des matériaux des quatrième et cinquième couches (4, 5).

4. Détecteur selon la revendication 1, caractérisé en ce que les moyens de peuplement d'électrons correspondent à un dopage permettant un peuplement en électrons du premier niveau d'énergie (e1).

5. Détecteur selon la revendication 4, caractérisé en ce que la première couche (1) est dopée de type N.

6. Détecteur selon la revendication 4, caractérisé en ce que l'une quelconque au moins desdites couches (1 à 5) est dopée de type N.

7. Détecteur selon l'une des revendications 1 ou 2, caractérisé en ce que les moyens de peuplement d'électrons comportent des moyens (ME) émettant vers la structure une onde lumineuse de pompe propre au peuplement du premier niveau d'énergie (e1) par des électrons.

8. Détecteur selon l'une des revendications 1, ou 2 caractérisé en ce que les différentes couches sont réalisées avec les matériaux suivants :
GaAs pour la première couche (1)
$Ga_{(1-x)} . Al_x As$ pour la deuxième et la troisième couches (2, 3)
$Ga_{(1-y)} Al_y As$ pour la quatrième et la cinquième couches (4, 5).

9. Détecteur selon l'une des revendications 1 ou 2, caractérisé en ce qu'il comporte plusieurs successions de couches (1 à 5) constituant plusieurs puits quantiques empilés.

10. Détecteur selon l'une des revendications 1 ou 2, caractérisé en ce qu'il est réalisé sur un substrat semi-isolant.

11. Détecteur selon l'une des revendications 1 ou 2, caractérisé en ce que les moyens de commande de l'absorption de l'onde à détecter comporte deux électrodes (E1, E2) situées de part et d'autre de la structure connectées aux bornes d'une source de tension (MC) et permettant l'appliquer un champ électrique E à la structure.

12. Détecteur selon la revendication 11, caractérisée en ce qu'il comporte dans le circuit électrique d'application du champ électrique un détecteur de courant détectant un courant dû à la détection d'une onde électromagnétique.

13. Détecteur selon la revendication 2, caractérisé en que les moyens de peuplement en trous correspondent à un dopage de type P de l'une quelconque au moins lesdites couches (1 à 5).

14. Détecteur selon l'une quelconque des revendications 1 ou 2, caractérisé en ce que les moyens de peuplement d'électrons ou en trous comportent une source de rayonnement éclairant le puits quantique de façon à créer des électrons dans la bande de conduction correspondant à des trous dans la bande de valence.

15. Détecteur selon la revendication 1, caractérisé en ce que la différence d'énergie entre le premier niveau permis (e$_1$) et le deuxième niveau est sensiblement égale à l'énergie photonique de l'onde à détecter (hν).

**Patentansprüche**

1. Detektor zur Erfassung einer elektromagnetischen Welle (hν),
   - mit einer Halbleiterstruktur, die mindestens eine erste Schicht (1) eines ersten Materials, umgeben von einer zweiten und dritten Schicht (2, 3) aus einem zweiten Material besitzt, wobei das Ganze von einer vierten und einer fünften Schicht (4, 5) eines dritten Materials umgeben ist und die Struktur das folgende Potentialenergieprofil entsprechend dem unteren Ende des Leitungsbandes für die Elektronen ergibt:
   - eine verhältnismäßig geringe Energie für die erste Schicht (1), die ein Bezugsenergieniveau (0) liefert,
   - eine Zwischenenergie für die zweite Schicht (2) und die dritte Schicht (3),
   - eine Energie eines höheren Werts für die vierte Schicht (4) und die fünfte Schicht (5), dadurch gekennzeichnet, daß die Energie entsprechend einem ersten erlaubten Niveau (e1) geringer als die potentielle Energie (V1) am unteren Ende des Leitungsbandes eines der zur Bildung der zweiten und dritten Schichten (2, 3) verwendeten Materialien ist, daß die Energie entsprechend einem zweiten Niveau (e2) zwischen der potentiellen Energie (V1) am unteren Ende des Leitungsbandes der Materialien der zweiten Schicht (2) und der dritten Schicht (3) und der potentiellen Energie (V1 + V2) am unteren Ende des Leitungsbandes der Materialien der vierten Schicht (4) und der fünften Schicht (5) liegt,
   - daß Mittel zur Bevölkerung des ersten erlaubten Energieniveaus (e$_1$) des Quantenbrunnens mit Elektronen,
   - und Mittel vorgesehen sind, um ein elektrisches Feld senkrecht zur Ebene der Struktur anzulegen.

2. Detektor zur Erfassung einer elektromagnetischen Welle (hν),
   - mit einer Halbleiterstruktur, die mindestens eine erste Schicht (1) eines ersten Materials, umgeben von einer zweiten und einer dritten Schicht (2, 3) aus einem zweiten Material besitzt, wobei das Ganze von einer vierten und einer fünften Schicht (4, 5) eines dritten Materials umgeben ist und die Struktur das folgende Potentialenergieprofil entsprechend dem oberen Ende des Valenzbandes für die Löcher ergibt:
   - eine verhältnismäßig geringe Energie für die erste Schicht (1), die ein Bezugsenergieniveau (0) liefert,
   - eine Zwischenenergie für die zweite Schicht (2) und die dritte Schicht (3),
   - eine Energie eines höheren Werts für die vierte Schicht (4) und die fünfte Schicht (5), dadurch gekennzeichnet, daß die Energie entsprechend einem ersten erlaubten Niveau geringer als die potentielle Energie (V1) am oberen Ende des Valenzbandes eines der zur Bildung der zweiten und dritten Schichten (2, 3) verwendeten Materialien ist, daß die Energie entsprechend einem zweiten Niveau (e2) zwischen der potentiellen Energie (V1) am oberen Ende des Valenzbandes der Materialien des zweiten Bands (2) und des dritten Bands (3) und der potentiellen Eenrgie (V1 + V2) am oberen Ende des Valenzbandes der Materialien der vierten Schicht (4) und der fünften Schicht (5) liegt,
- daß Mittel zur Bevölkerung des ersten erlaubten Energieniveaus des Quantenbrunnens mit Löchern vorgesehen sind.

3. Detektor nach Anspruch 1, dadurch gekennzeichnet, daß die Halbleiterstruktur mehrere Niveaus (e2 bis e5) zwischen der potentiellen Energie (V1) am unteren Ende des Leitungsbandes der Materialien der zweiten Schicht (2) und der dritten Schicht (3) und der potentiellen Energie (V1 + V2) am unteren Ende des Leitungsbandes der Materialien der vierten Schicht (4) und der fünften Schicht (5) besitzt.

4. Detektor nach Anspruch 1, dadurch gekennzeichnet, daß die Mittel zur Bevölkerung mit Elektronen einer Dotierung entsprechen, durch die das erste Energieniveau (e1) mit Elektronen bevölkert werden kann.

5. Detektor nach Anspruch 4, dadurch gekennzeichnet, daß die erste Schicht (1) eine N-Dotierung besitzt.

6. Detektor nach Anspruch 4, dadurch gekennzeichnet, daß mindestens eine beliebige der Schichten (1 bis 5) eine N-Dotierung besitzt.

7. Detektor nach einem der Ansprüche 1 oder 2, dadurch gekennzeichnet, daß die Mittel zu Bevölkerung mit Elektronen Mittel (ME) besitzen, die in die Struktur eine Pumplichtwelle hineinsenden, die in der Lage ist, das erste Energieniveau (e1) mit Elektronen zu bevölkern.

8. Detektor nach einem der Ansprüche 1 oder 2, dadurch gekennzeichnet, daß die verschiedenen Schichten mit folgenden Materialien hergestellt werden:

GaAs für die erste Schicht (1),
$Ga_{(1-x)}Al_x$ für die zweite und dritte Schicht (2, 3),
$Ga_{(1-y)}Al_y$As für die vierte und fünfte Schicht (4, 5).

9. Detektor nach einem der Ansprüche 1 oder 2, dadurch gekennzeichnet, daß er mehrere Folgen von Schichten (1 bis 5) enthält, die mehrere übereinanderliegende Quantenbrunnen bilden.

10. Detektor nach einem der Ansprüche 1 oder 2, dadurch gekennzeichnet, daß er auf einem halbisolierenden Substrat hergestellt ist.

11. Detektor nach einem der Ansprüche 1 oder 2, dadurch gekennzeichnet, daß die Mittel zur Steuerung der Absorption der zu erfassenden Welle zwei Elektroden (E1, E2) zu beiden Seiten der Struktur besitzen, die an die Klemmen einer Spannungsquelle (MC) angeschlossen sind und ein elektrisches Feld E an die Struktur anlegen können.

12. Detektor nach Anspruch 11, dadurch gekennzeichnet, daß er im elektrischen Kreis zum Anlegen des elektrischen Feldes einen Stromdetektor aufweist, der einen Strom aufgrund der Erfassung einer elektromagnetischen Welle mißt.

13. Detektor nach Anspruch 2, dadurch gekennzeichnet, daß die Mittel zur Bevölkerung mit Löchern einer P-Dotierung mindestens einer beliebigen der Schichten (1 bis 5) entsprechen.

14. Detektor nach einem beliebigen der Ansprüche 1 oder 2, dadurch gekennzeichnet, daß die Mittel zur Bevölkerung mit Elektronen oder Löchern eine Strahlungsquelle aufweisen, die den Quantenbrunnen so bestrahlt, daß Elektronen im Leitungsband erzeugt werden, die Löchern im Valenzband entsprechen.

15. Detektor nach Anspruch 1, dadurch gekennzeichnet, daß die Energiedifferenz zwischen dem ersten erlaubten Niveau ($e_1$) und dem zweiten Niveau im wesentlichen gleich der Photonenenergie der zu erfassenden Welle (hv) ist.

## Claims

1. Electromagnetic wave detector for the detection of a wave (hv) to be detected, comprising:
   - a semiconductor structure possessing at least a first layer (1) of a first material flanked between a second layer (2) and a third layer (3) which are of a second material, the assembly being flanked by a fourth layer (4) and a fifth layer (5) which are of a third material, this structure making it possible to obtain the potential energy profile corresponding to the bottom of the conduction band for electrons:
   - a relatively low energy for the first layer (1) providing an energy reference (0);
   - an intermediate energy for the second and third layers (2, 3);
   - an energy of greater value for the fourth and fifth layers (4, 5),
   characterised in that the energy corresponding to a first permitted level (e1) is less than the potential energy (V1) of the bottom of the conduction band of both materials used for manufacturing the second and third layers (2, 3), the energy corresponding to a second level (e2) lies between the potential energy (V1) of the bottom of the conduction band of both materials of the second and third layers (2, 3) and the potential energy (V1 + V2) of the bottom of the conduction band of both materials of the fourth and fifth layers (4, 5);
- means for populating with electrons the first permitted energy level ($e_1$) of the quantum well;
- means for applying an electric field perpendicularly to the plane of the structure.

2. Electromagnetic wave detector for the detection of a wave (hν) to be detected, comprising:
- a semiconductor structure possessing at least a first layer (1) of a first material flanked between a second layer (2) and a third layer (3) which are of a second material, the assembly being flanked by a fourth layer (4) and a fifth layer (5) which are of a third material, this structure making it possible to obtain the potential energy profile corresponding to the top of the valence band for holes:
- a relatively low energy for the first layer (1) providing an energy reference (0);
- an intermediate energy for the second and third layers (2, 3);
- an energy of greater value for the fourth and fifth layers (4, 5),
characterised in that the energy corresponding to a first permitted level is less than the potential energy (V1) of the top of the valence band of both materials used for manufacturing the second and third layers (2, 3), the energy corresponding to a second level (e2) lies between the potential energy (V1) of the top of the valence band of both materials of the second and third layers (2, 3) and the potential energy (V1 + V2) of the top of the valence band of both materials of the fourth and fifth layers (4, 5),
- means for populating with holes the first permitted energy level of the quantum well.

3. Detector according to Claim 1, characterised in that the semiconductor structure possesses several levels (e2 to e5) lying between the potential energy (V1) of the bottom of the conduction band of the materials of the second and third layers (2, 3) and the potential energy (V1 + V2) of the bottom of the conduction band of the materials of the fourth and fifth layers (4, 5).

4. Detector according to Claim 1, characterised in that the means for populating with electrons correspond to a doping enabling the first energy level (e1) to be populated with electrons.

5. Detector according to Claim 4, characterised in that the first layer (1) is n-type doped.

6. Detector according to Claim 4, characterised in that at least any one of the said layers (1 to 5) is n-type doped.

7. Detector according to either of Claims 1 or 2, characterised in that the means for populating with electrons include means (ME) emitting, towards the structure, a light pump wave suitable for populating the first energy level (e1) with electrons.

8. Detector according to either of Claims 1 or 2, characterised in that the various layers are produced with the following materials:
GaAs for the first layer (1)
$Ga_{(1-x)} \times Al_x$ for the second and third layers (2, 3)
$Ga_{(1-y)} Al_y$ As for the fourth and fifth layers (4, 5).

9. Detector according to either of Claims 1 or 2, characterised in that it includes several successions of layers (1 to 5) constituting several stacked quantum wells.

10. Detector according to either of Claims 1 or 2, characterised in that it is produced on a semi-insulating substrate.

11. Detector according to either of Claims 1 or 2, characterised in that the means for controlling the absorption of the wave to be detected includes two electrodes (E1, E2) located on each side of the structure, connected to the terminals of a voltage source (MC) and enabling an electric field E to be applied to the structure.

12. Detector according to Claim 11, characterised in that it includes, in the electric circuit for applying the electric field, a current detector detecting a current due to the detection of an electromagnetic wave.

13. Detector according to Claim 2, characterised in that the means for populating with holes correspond to a p-type doping of at least any one of the said layers (1 to 5).

14. Detector according to either of Claims 1 or 2, characterised in that the means for populating with electrons or with holes include a radiation source illuminating the quantum well so as to create electrons in the conduction band corresponding to holes in the valence band.

15. Detector according to Claim 1, characterised in that the energy difference between the first permitted level ($e_1$) and the second level is substantially equal to the photonic energy of the wave ($h\nu$) to be detected.

BANDE DE CONDUCTION

hv

hv

hv

Exemples :

HgCdTe
PbSnTe

Exemples :

Ge : Hg
Si : As

Exemples :

Puits Quantiques : III V
Ga As / GaAl As...
InP / GaIn As

FIG.1a

FIG.1b

FIG.1c

BANDE DE VALENCE

EP 0 407 250 B1

BANDE DE CONDUCTION

$\varepsilon$

$e_2$

$\phi$

$l_2$

$hv$

$hv$

$e_1$

$l_1$

BANDE INTERDITE

$d_1$

# FIG.2a

BANDE DE CONDUCTION

$e'_2$

$e_1$

$l_1$

BANDE INTERDITE

$d_1$

# FIG.2b

FIG.3a

FIG.3b

FIG.4a

FIG.4b

EP 0 407 250 B1

FIG.5

FIG.6

FIG.7

FIG.8

# FIG_9

hγ

E1
7
3 5
2 1
4
N⁺
6
N⁺
SUBSTRAT
E2

DET
MC

# FIG_10

e2
4
5
e1
2
1
3